# EUROPÄISCHE PATENTSCHRIFT

(11) **EP 0 349 882 B1**
(45) Veröffentlichungstag und Bekanntmachung des Hinweises auf die Patenterteilung: **16.03.1994**
(21) Anmeldenummer: 89111636.0
(22) Anmeldetag: 27.06.1989
(51) Int. Cl.: C23C 18/14, C23C 18/16

(54) **Verfahren zur Herstellung von metallischen Schichten**
Process for manufacturing metal layers
Procédé de fabrication de couches métalliques

(30) Priorität: 02.07.1988 DE 3822494
(43) Veröffentlichungstag der Anmeldung: 10.01.1990
(73) Patentinhaber: Heraeus Noblelight GmbH, D-63801 Kleinostheim (DE)
(72) Erfinder: Kogelschatz, Ulrich, Dr., CH-5212 Hausen bei Brugg (CH); Esrom, Hilmar, Dr., D-6900 Heidelberg (DE); Sutcliffe, Emil, Dr., CH-5600 Lenzburg (CH)
(74) Vertreter: Kühn, Hans-Christian

(56) Entgegenhaltungen:
- EP-A- 0 272 420
- US-A- 3 904 783
- M.F.Gross et al. "Photon and Ion Beam Induced Chemistry of Palladium Acetate Films, Mat. Res. Soc.Proc.75 (1987);pp.91-97"

## Beschreibung

Die Erfindung bezieht sich auf ein Verfahren zur Herstellung von ganzflächigen oder partiellen metallischen Schicht gemäß dem Oberbegriff des Patentanspruches 1.

Aus der Informationsschrift "M. E. Gross et al, "Photon and Ion Beam-Induced Chemistry of Palladium Acetate Films, pp.91-97 (Mat. Res. Soc. Symp. Proc., Vol. 75, 1987)" ist ein Verfahren zur Herstellung von metallischen Schichten auf einem Substrat bekannt. Bei diesem Verfahren werden in Lösungsmitteln gelöste metallorganische Verbindungen auf die Oberfläche eines Substrates aufgetragen. Zur Ausbildung einer metallischen Schicht auf dem Substrat wird die Lösung mit einer Lichtquelle hoher Leistung bestrahlt. Für die Fertigstellung der metallischen Schichten sind zusätzliche Trockungsprozesse erforderlich.

Aus der US-A-3,904,783 ist ein Verfahren zum Ausbilden von metallischen Schichten auf einem Substrat bekannt. Hierfür wird aus einem Lösungsgemisch das Metallsalz einer organischen Säure gebildet, und gelöst auf ein Substrat aufgetragen. Anschließend wird dieses Lösung mit UV-Strahlung bestrahlt, wobei eine metallische Schicht gebildet wird. Anschließend werden die Reste der nicht zersetzten Lösung mit Hilfe einer Natriumhydroxidlösung entfernt.

Der Erfindung liegt die Aufgabe zugrunde, ein Verfahren aufzuzeigen, mit dem metallische Schichten einfacher und energiesparender als bisher auf Substrate aufgetragen werden können.

Diese Aufgabe wird durch die Merkmale des Patentanspruchs 1 gelöst. Weitere Vorteilhafte Ausführungsformen sind in den abhängigen Ansprüchen 2 - 4 enthalten.

Mit Hilfe des erfindungsgemäßen Verfahrens können aus pulverförmigen metallorganischen Verbindungen, die auf ein Substrat aufgetragen werden, alleine durch energiereiche UV-Photonenbestrahlung unmittelbar metallische Schichten gebildet werden. Vorzugsweise besteht der metallische Anteil der metallorganischen Verbindung aus Kupfer, Palladium, Platin oder Gold. Unter Zuhilfenahme von Masken lassen sich die metallischen Schichten an definierter Stelle auf dem Substrat ausgebilden. Die nicht mit dem UV-Licht bestrahlten Pulverteilchen können anschließend problemlos von der Oberfläche des Substrats abgenommen werden. Umweltbelastende Lösungsmittel werden nicht freigesetzt. Zusätzliche Trocknungsprozesse entfallen und Benetzungsprobleme beim Auftragen der Lösung auf die Substratoberfläche treten nicht auf.

Für die Bestrahlung der pulverförmigen metallorganischen Verbindung wird ein UV-Hochleistungsstrahler mit quasigepulster Betriebsart verwendet. Das von dem Hochleistungsstrahler ausgesendete Licht weist eine Wellenlänge auf, die je nach Gasfüllung des UV-Hochleistungsstrahlers zwischen 100 nm und 360 nm liegt. Anstelle des UV-Hochleistungsstrahlers kann zur Ausbildung der metallischen Schichten auf dem Substrat auch eine Hochleistungsquecksilberlampe mit einer Wellenlänge von 158 nm verwendet werden. Für die Ausbildung der metallischen Schichten werden pulverförmiger Metallacetate, Metallacetylacetonate und Metallformiate auf die Substratoberfläche aufgetragen. Die Dicke der aufgetragenen Pulverschicht beträgt 50 nm bis 150 nm. Das Substrat, auf welchem die metallische Schicht ausgebildet werden soll, kann aus einem organischen oder anorganischen werkstoff bestehen. Eine besonders gute Haftfestigkeit der metallischen Schicht kann auf Substraten aus Aluminiumoxid und Aluminiumnitrid (AlN) erzielt werden. Die fertiggestellten Schichten können zusätzlich durch stromlose oder galvanische Metallisierung verstärkt werden.

Weitere erfindungswesentliche Merkmale sind in den Unteransprüchen gekennzeichnet.

Es zeigen:
- Figur 1:: Die strukturierte Beschichtung eines Substrats,
- Figur 2:: das beschichtete Substrat gemäß Figur 1,
- Figur 3:: ein ganzflächig beschichtetes Substrat mit zusätzlicher Metallisierung.

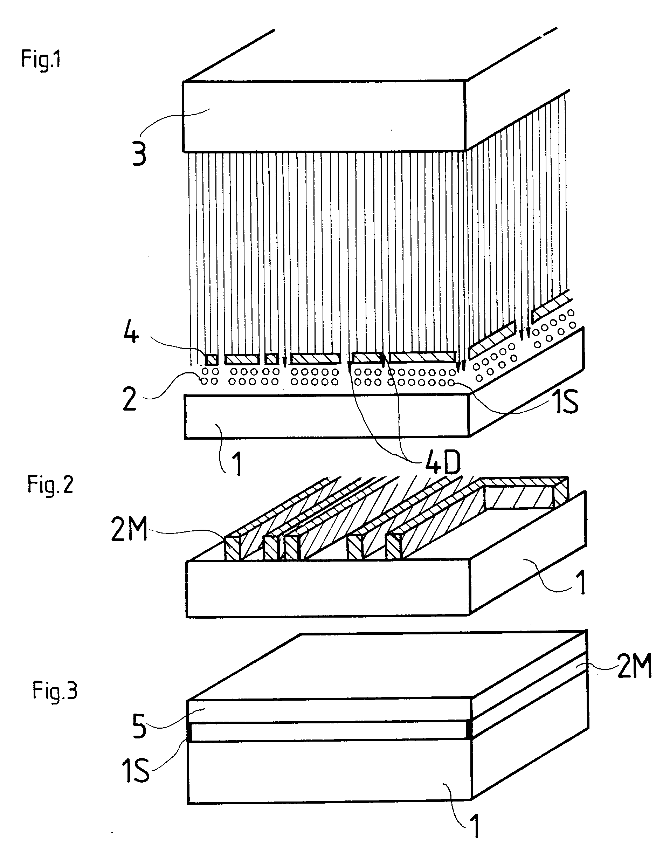

Figur 1 zeigt ein flächiges Substrat 1 mit rechteckigem Querschnitt, auf dessen Oberfläche eine metallische Schicht abgeschieden werden soll. Das Substrat 1 ist bei dem hier dargestellten Ausführungsbeispiel aus Aluminiumoxid (Al₂O₃) gefertigt. Die metallische Beschichtung kann jedoch auch auf anderen Substraten (hier nicht dargestellt) aus einem organischen oder anorganischen werkstoff aufgebracht werden. Die verwendeten Substrate können jede beliebige geometrische Form aufweisen, vorzugsweise werden jedoch dünne Platten verwendet, die aus Aluminiumnitrid, Borsilikatglas, Polyimid, Gummi, Papier oder Pappe sowie aus keramisch gefüllten oder glasgewebeverstärkten Fluorkunststoffen hergestellt sind. Auf die gereinigte Oberfläche des Substrats 1 wird zunächst eine pulverförmige metallorganische Verbindung 2 aufgetragen. Die Dicke des aufgetragenen Pulvers wird so gewählt, daß die zu bildende metallische Schicht im fertigen Zustand eine Dicke von 50 nm aufweist. Das verwendete Pulver weist vorzugsweise eine Korngröße von 25 bis 150 µm auf. Als metallorganische Verbindung können Metallacetate, Metallacetylacetonate und Metallformiate verwendet werden. Soll beispielsweise die zu bildende metallische Schicht 2M aus Palladium bestehen, so wird auf die zu beschichtende Oberfläche 1S des Substrates 1 pulverförmiges Palladiumacetat aufgetragen. Zur Ausbildung einer aus Kupfer bestehenden metallischen Schicht wird Kupferacetat oder eine andere metallorganische Verbindung aufgetragen, deren metallischer Anteil aus Kupfer besteht. Ein strukturiertes Auftragen des Pulvers ist mittels Siebdruck oder Sprühen möglich.

In definiertem Abstand über der zu beschichtenden Oberfläche 1S des Substrates 1 ist ein UV-Hochleistungsstrahler 3 angeordnet. In Figur 1 ist dieser Hochleistungsstrahler 3 nur schematisch dargestellt. Eine detaillierte Beschreibung eines solchen Hochleistungsstrahlers 3 kann der EP-A-0 254 111 entnommen werden. Der Hochleistungsstrahler 3 besteht aus einem durch eine einseitig gekühlte Metallelektrode (hier nicht dargestellt) und ein Dielektrikum (hier ebenfalls nicht dargestellt) begrenzten und mit einem Edelgas oder Gasgemisch gefüllten Entladungsraum (hier nicht dargestellt). Das Dielektrikum und die auf der dem Entladungsraum abgewandten Oberfläche des Dielektrikums liegende zweite Elektrode sind für die durch stille elektrischen Entladung erzeugte Strahlung transparent. Durch diese Konstruktion und durch eine geeignete Wahl der Gasfüllung wird ein großflächiger UV-Hochliestungsstrahler mit hohem Wirkungsgrad geschaffen. Mit einer Edelgasfüllung aus Argon kann eine UV-Strahlung im Wellenlängenbereich zwischen 107 und 165 nm erzeugt werden. Mit Hilfe einer Gasmischung aus Xenon und Chlor können UV-Strahlungen mit einer Wellenlänge zwischen 300 und 360 nm erzeugt werden. Der Hochleistungsstrahler 3 arbeitet mit einem quasigepulsten Betrieb. Soll das zu beschichtende Substrat 1 auf seiner gesamten Oberfläche mit einer Metallschicht versehen werden, so wird ein Hochleistungsstrahler 3 verwendet, dessen Strahlungsfeld der Größe der Substratoberläche 1S entspricht. Falls die aufzutragende metallische Schicht 2M eine definierte Struktur aufweisen soll, besteht die Möglichkeit, daß zwischen dem Hochleistungsstrahler 3 und der Oberfläche 1S des Substrates 1 eine oder mehrere optische Linsen (hier nicht dargestellt) angeordnet werden. Mit deren Hilfe kann eine die gewünschte Struktur bestimmende Maske auf der Oberfläche 1S des Substrates 1 abgebildet werden. dies ist insbesondere dann vorteilhaft, wenn die aufzutragende Schicht komplexe Strukturen wie Linien oder Spiralen aufweisen soll. Mit Hilfe der Linsen können die Strahlen so fokussiert werden, daß sie gerade die Breite dieser Linien bzw. Spiralen aufweisen. Die Maske kann jedoch auch unmittelbar über der Pulverschicht 2 positioniert werden. Die Maske 4 ist an die Abmessung der Oberfläche angepaßt und weist gerade an den Stellen, an denen die strukturierte metallische Beschichtung 2M ausgebildet werden soll, Durchlässe 4D für die von dem UV-Hochliestungsstrahler 3 kommende Strahlung auf. Die Bestrahlung der Pulverschicht 2 durch die Durchlässe 4D hindurch wird wenige Sekunden bis hin zu einigen Minuten lang durchgeführt. Diese Zeit wird von den jeweiligen Gegebenheiten bestimmt. durch das Bestrahlen der Pulverschicht 2 wird die metallorganische Verbindung unter gleichzeitiger Bildung der metallischen Schicht zersetzt. Bei Verwendung einer Maske 4 haben die gebildeten metallischen Schichten die Breite und die Länge der in der Maske 4 vorgesehenen Durchlässe 4D. Die Pulverschichten 2, welche durch die Maske 4 vor einer Bestrahlung abgeschirmt wurden, können jetzt mit Hilfe eines Gasstrahles von der Oberfläche 1S des Substrates 1 entfernt werden.

Anstelle des eingangs beschriebenen UV-Hochleistungsstrahlers 3 kann auch eine Hochleistungsquecksilberlampe mit einer Wellenlänge von 158 nm für die Ausbildung der metallischen Schichten eingesetzt werden. Erfindungsgemäß kann die Geometrie des verwendeten UV-Hochleistungsstrahlers 3 bzw. der Hochleistungsquecksilber lampe an die Geometrie der zu beschichtenden Substrate angepaßt werden. Es ist bspw. durchaus möglich, die Beschichtung von rechteckigen Substraten im Sekundetakt auf einem Fließband durchzuführen. Hierfür wird die Lampengeometrie auf den rechteckigen Querschnitt des zu beschichtenden Substrats abgestimmt. Zusätzlich werden die Länge der Lampe und die Geschwindigkeit des Bandes, auf welche die Substrate gelegt werden, so aufeinander abgestimmt, daß das jeweilige Substrat 1 solange unter einer Lampe 3 hindurch bewegt wird, wie es für die Ausbildung der metallischen Schicht 2M auf seiner Oberfläche 2S erforderlich ist. Die gewünschte Produktionsrate kann durch Wahl der o.g. Parameter erzielt werden.

Figur 2 zeigt ein Substrat 1, das mit dem erfindungsgemäßen Verfahren unter Verwendung des UV-Hochleistungsstrahlers 3 und der in Figur 1 gezeigten Maske 4 beschichtet wurde. Das Substrat 1 weist die zu Beginn des Verfahrens festgelegte strukturierte Beschichtung auf, die zum einen mit Hilfe der Maske 4 und zum anderen durch ein gezieltes Auftragen der pulverförmigen metallorganischen Verbindung erreicht wird.

In Figur 3 ist ein weiteres Substrats 1 dargestellt, dessen Oberfläche 1S vollständig von einer metallischen Schicht 2M überzogen ist. Die Ausbildung dieser metallischen Schicht 2M erfolgt wiederum durch Auftragen einer metallorganischen Verbindung in Pulverform auf die Oberfläche 1S des Substrates 1. Anschließend wird die Pulverschicht 2 komplett von dem UV-Hochleistungsstrahler 3 bestrahlt, so daß das gesamte Pulver zersetzt und in eine metallische Schicht 2M umgewandlet wird. Die in Figur 3 dargestellte Metallschicht 2M ist zusätzlich durch einen weiteren metallischen Überzug 5 verstärkt. Dieser metallische Überzug 5, der aus Kupfer oder einem anderen Metall bestehen kann, läßt sich durch stromlose oder galvanische Metallisierung ausbilden. Die in Figur 2 dargestellten strukturierten Metallschichten 2M können in gleicher Weise verstärkt werden.

## Patentansprüche

1. Verfahren zur Herstellung von ganzflächigen oder partiellen metallischen Schichten (2M) aus einer metallorganischen Verbindung auf einem Substrat (1) durch Bestrahlung mit einer UV-Lichtquelle (3), **dadurch gekennzeichnet,** daß ein pulverförmiges Metallacetat, Metallacetylacetonat oder Metallformiat, dessen Metallanteil durch Palladium, Kupfer, Platin oder Gold gebildet wird, in einer Dicke zwischen 10 und 150 nm auf das Substrat (1) aufgetragen und vollständig oder partiell der Strahlung eines UV-Hochleistungsstrahlers ausgesetzt wird, der UV-Strahlung mit einer Wellenlänge zwischen 100 nm und 360 nm erzeugt.

2. Verfahren nach Anspruch 1, dadurch gekennzeichnet, daß die ganzflächigen oder partiellen Schichten (2M) auf die Oberfläche (1S) von Substraten (1] organischen oder anorganischen Werkstoffen aufgetragen werden.

3. Verfahren nach einem der Ansprüche 1 oder 2, dadurch gekennzeichnet, daß die ganzflächigen oder partiellen metallischen Schichten (2M) durch stromlose oder galvanische Metallisierung verstärkt werden.

4. Verfahren nach einem der Ansprüche 1 bis 3, dadurch gekennzeichnet, daß die pulverförmigen Metallacetate, Metallacetylacetonate oder Metallformiate mittels Siebdruck oder Sprühen auf die Oberfläche (1S) des Substrats (1) aufgetragen werden.

## Claims

1. A method for the production of metallic layers (2M), over the entire surface, or partial, of an organometallic compound on a substrate (1) by irradiation with a UV light source (3), characterised in that a powdery metal acetate, metal acetyl acetonate or metal formate, the metal component of which is formed by palladium, copper, platinum or gold, is applied in a thickness of between 10 and 150 nm onto the substrate (1) and is exposed fully or partially to the radiation of a UV high power emitter, which produces UV radiation with a wave length between 100 nm and 360 nm.

2. A method according to Claim 1, characterised in that the layers (2M), over the entire surface, or partial, are applied onto the surface (1S) of substrates (1) of organic or inorganic materials.

3. A method according to one of Claims 1 or 2, characterised in that the metallic layers (2M), over the entire surface, or partial, are strengthened by zero current or galvanic metallisation.

4. A method according to one of Claims 1 to 3, characterised in that the pulverulent metal acetates, metal acetyl acetonates or metal formates are applied by means of screen printing or spraying onto the surface (1S) of the substrate (1).

## Revendications

1. Procédé pour la réalisation de couches métalliques (2M) complètes ou partielles d'un composé organométallique sur un substrat (1) par irradiation avec une source de rayons UV (3), caractérisé en ce qu'on applique une acétate métallique, un acétylacétonate métallique ou un formiate métallique sous forme de poudre, dont la partie métallique est formée par du palladium, du cuivre, du platine ou de l'or, sur une épaisseur comprise entre 10 et 150 nm sur le substrat (1) et on le soumet entièrement ou partiellement au rayonnement d'un émetteur de rayonnement UV à forte puissance, qui produit un rayonnement UV avec une longueur d'onde comprise entre 100 nm et 360 nm.

2. Procédé selon la revendication 1, caractérisé en ce que les couches complètes ou partielles (2M) sont appliquées sur la surface (1S) des substrats (1) de matériaux organiques ou non organiques.

3. Procédé selon l'une des revendications 1 ou 2, caractérisé en ce que les couches métalliques complètes ou partielles (2M) sont renforcées par une métallisation sans courant ou galvanique.

4. Procédé selon l'une des revendications 1 à 3, caractérisé en ce que l'acétate métallique, l'acétylacétonate métallique ou le formiate métallique sous forme de poudre sont appliqués par sérigraphie ou par pulvérisation sur la surface (1S) du substrat (1).
